# EUROPEAN PATENT APPLICATION

(11) **EP 1 065 667 A2**
(43) Date of publication of application: **03.01.2001**
(21) Application number: 00113579.7
(22) Date of filing: 27.06.2000
(51) Int. Cl.: G11C 16/06

(54) **Microcomputer with a flash memory and rewrite count management method**

(30) Priority: 29.06.1999 JP 18265499
(71) Applicant: NEC CORPORATION, Tokyo (JP)
(72) Inventor: Nagata, Masahiko, Minato-ku, Tokyo (JP)
(74) Representative: Baronetzky, Klaus, Dipl.-Ing.

(57) **Abstract**

A program execution area, a rewrite area, and a rewrite count area are provided in a flash memory. The rewrite count area comprises rewrite count management areas each managing a rewrite count corresponding to a block constituting the rewrite area. A rewrite count management area which is in the rewrite count area and which corresponds to a block of the rewrite area is composed of a bit string containing the number of bits equal to or larger than the maximum allowable rewrite count. All the bits of this bit string is set to the same value at initialization. When a block is rewritten, the value of the bit in the position which is in the rewrite count management area and which corresponds to the rewrite count of the block is inverted.

## Description

### FIELD OF THE INVENTION

The present invention relates to an electrically re-writable, erasable non-volatile semiconductor memory device, and more particularly to a technology for managing a flash memory rewrite count.

### BACKGROUND OF THE INVENTION

In a flash memory (an electrically re-writable, erasable read-only memory that can be erased, block by block at a time; also called a flash EEPROM), a voltage at a predetermined level, when applied across the source, control gate, and drain of each memory cell transistor having a floating gate, causes electrons to be injected into the floating gate to program the flash memory. Conversely, the electric charge is removed, for example, through tunnel emission to erase the flash memory. At this time, a block, as a unit, of memory cell transistors sharing a source line is erased at a time.

In general, the maximum allowable rewrite count of a flash memory installed on a microcomputer is about 100 at the most. The maximum allowable rewrite count of this flash memory is much smaller than that of a general-purpose flash memory. Therefore while a general-purpose flash memory may be re-written with no concern about the rewrite count, a flash memory installed on a microcomputer must be carefully managed for its rewrite count, for example, when self-programming etc. is performed.

There have been several methods for managing the rewrite count of a flash memory installed on a microcomputer. For example, in addition to a flash memory 100' installed on a microcomputer, an external general-purpose, non-volatile memory 104 having a sufficiently larger maximum allowable rewrite count is separately provided to store the rewrite count of the flash memory 100'. During self-programming, the rewrite control program is loaded from the flash memory 100' into a main memory 102. A CPU 101 executes this program to control the drain voltage controller, source voltage controller, word line (control gate voltage) controller, and so on, to control the erase and rewrite operation.

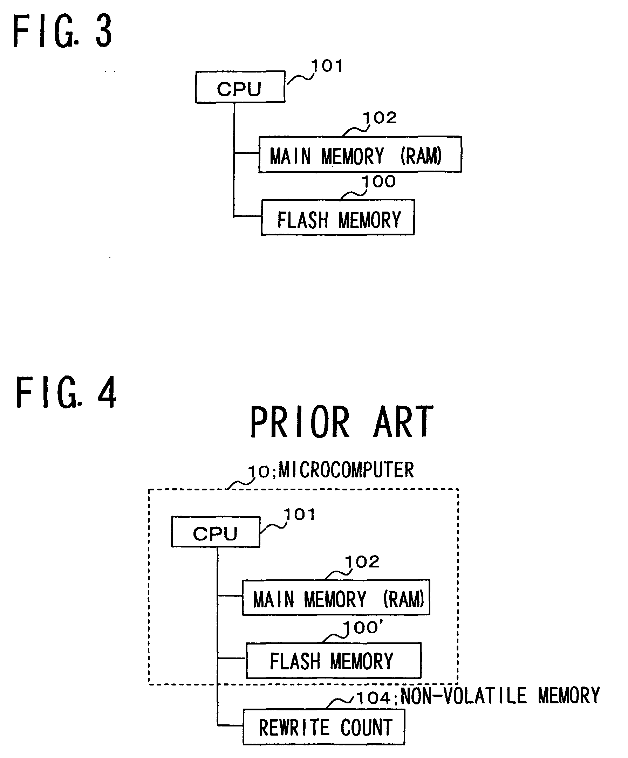

Each time the flash memory 100' of a microcomputer 10 with a built-in flash memory, shown in FIG. 4, is self-programmed, the rewrite count stored in the non-volatile memory 104, provided externally to the microcomputer 10, is updated. A check is made for the count to see if the rewrite count is smaller than or equal to the maximum allowable rewrite count. If the rewrite count exceeds the maximum allowable rewrite count, no further rewrite operation is allowed.

### SUMMARY OF THE DISCLOSURE

However, the configuration in which the non-volatile memory 104 is provided externally to the microcomputer increases the product cost.

On the other hand, when the rewrite count is managed in a microcomputer with a flash memory without using an external non-volatile memory, the rewrite count storage area and the rewrite area in the flash memory are rewritten the same number of times. This configuration deteriorates both of these areas to the same degree and decreases the reliability of data whose rewrite count is managed. Therefore, it has been virtually difficult to manage the rewrite count using only the flash memory installed on the microcomputer.

In view of the foregoing, it is an object of the present invention to provide a rewrite count management method and a rewrite count management system that can manage a rewrite count correctly using only a flash memory that is rewritten.

According to a first aspect of the present invention, a microcomputer according to the present invention provides, in a flash memory, a rewrite area to be rewritten and a rewrite count area for managing the rewrite count of the rewrite area. The rewrite count area comprises rewrite count management areas each managing the rewrite count corresponding to each of blocks constituting the rewrite area. When one of the blocks is rewritten, the value of the bit position which is in the rewrite count management area corresponding to the one block and which corresponds to the rewrite count of the block is changed.

In the microcomputer, when one of the blocks of the rewrite area is rewritten, the microcomputer searches the rewrite count area for the rewrite count management area corresponding to the block; determines the rewrite count from bit data whose value has been changed in the rewrite count management area; and, if the rewrite count is equal to or smaller than a predetermined maximum rewrite count, erases the block and writes data therein

According to a second aspect of the present invention, there is provided a flash memory rewrite management method, the method comprising the steps of: providing a rewrite count area that manages rewrite count data of a rewrite area, the rewrite count area being provided in the flash memory in addition to the rewrite area to be rewritten; providing, in the rewrite count area, a rewrite count management area for each of blocks constituting the rewrite area; and when a block in the rewrite area is rewritten, changing a value of a bit position corresponding to a rewrite count of the block, the bit position being in the rewrite count management area corresponding to the block.

The method further comprises the steps of: upon rewriting the block included in the rewrite area, searching the rewrite count area for the rewrite count management area corresponding to the block; determining the rewrite count based on data of bit or bits, whose value has been changed in the rewrite count management area; and erasing the block and writing data therein, if the rewrite count is equal to or smaller than a predetermined maximum rewrite count.

In the method, each of the rewrite count management areas, each corresponding to one of the blocks, in the rewrite count area is composed of a bit string comprising a number of bits equal to or larger than a predetermined maximum rewrite count, the bit string being preset to a predetermined value, and
when the block is rewritten, the value of the bit position corresponding to the rewrite count is changed, the bit position being within the bit string in the rewrite count management area in the rewrite count area, the rewrite count management area corresponding to the block.

In the method, each of the rewrite count management areas, each corresponding to one of the blocks, in the rewrite count area is divided into a high-order bit string of a first number of bits and a low-order bit string of a second number of bits, a value of a product of the first number of bits and the second number of bits being equal to or larger than a maximum of the rewrite count of the flash memory, the high-order and the low-order bit strings each being preset to a predetermined value, and
when the block is rewritten, the value of the high-order bit string and/or the low-order bit string corresponding to the rewrite count is changed, the high-order bit string and/or the low-order bit string being in the rewrite count management area in the rewrite count area, the rewrite count management area corresponding to the block.

### BRIEF DESCRIPTION OF THE DRAWINGS

FIG. 1 is a diagram showing the configuration of a first embodiment of the present invention.
FIG. 2 is a diagram showing a rewrite count storage area of another embodiment of the present invention and the rewrite count storage area of the first embodiment.
FIG. 3 is a diagram showing the outline configuration of a microcomputer in the embodiment of the present invention.
FIG. 4 is a diagram showing the outline configuration of a conventional microcomputer.

### PREFERRED EMBODIMENTS OF THE INVENTION

Some embodiments of the present invention will be described. On a microcomputer having a flash memory according to the present invention, when a program stored in a part of the flash memory executes self-programming to rewrite other areas, the rewrite count is stored in a separate area of the same flash memory as data. This configuration eliminates the need for an external non-volatile memory, thus managing the rewrite count correctly and reliably.

According to preferred embodiment of the present invention, the flash memory comprises a program execution area (100A), a rewrite area (100C) to be rewritten, and a rewrite count area (100B) for storing and managing rewrite count data on the rewrite area (100C). The rewrite count area (100B) comprises a plurality of rewrite count management areas each corresponding to one of a plurality of blocks constituting the rewrite area (100C). When one of the blocks of the rewrite area is rewritten, the value of the bit position which is in the rewrite count management area (100B) corresponding to the block and which corresponds to the rewrite count is changed.

As described above, the rewrite count of the flash memory is counted in the embodiment of the present invention by the number of bits (positional information) whose values have been changed in the rewrite count area of the flash memory. The value of a bit is changed, not by erasing, but only by overwriting.

The embodiment of the present invention prevents a deterioration in the characteristics caused by the erase operation performed on the flash memory area in which rewrite count data is stored. This method increases the reliability of rewrite count data.

The embodiment of the present invention manages the count of rewriting, which is performed by self-programming and so on, without having to use an external non-volatile memory that is required in the prior art.

### DETAILED DESCRIOTION OF THE EMBODIMENTS

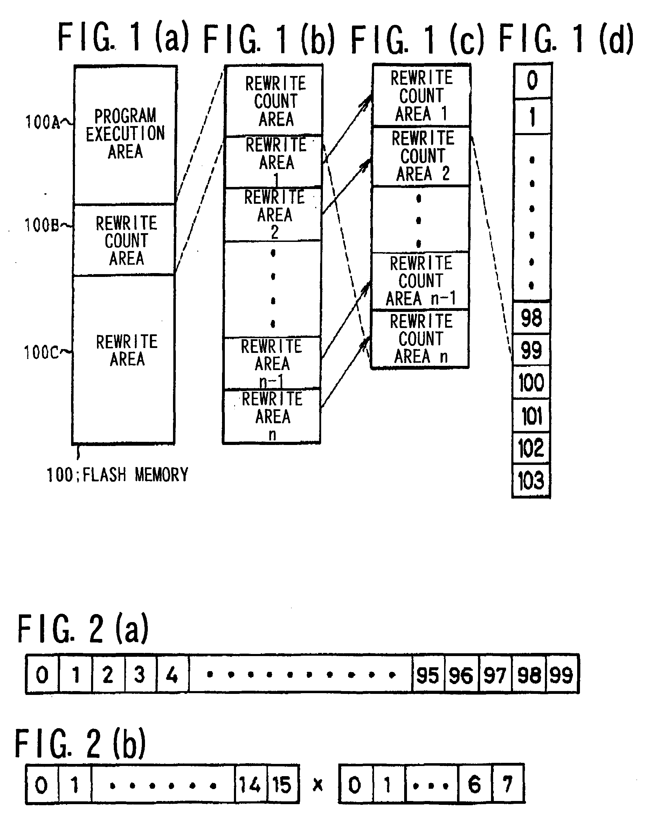

The embodiment of the present invention described above will be described below in more detail. FIG. 1 is a diagram showing an embodiment of the present invention. Referring to FIG. 1(a), the area of a flash memory 100 installed on a microcomputer is divided into three areas in this embodiment of the present invention: program execution area 100A, rewrite area 100C, and rewrite count area 100B.

The program execution area 100A stores therein a program executed for writing data into the rewrite area 100C. This program, when executed by the CPU, executes self-programming and rewrites data stored in the rewrite area 100C.

The rewrite area 100C contains data to be rewritten by the self-program stored in the program execution area 100A. As shown in FIG. 1 (b), this area is subdivided into blocks 1 - n. Each of these blocks is a minimum unit that can be erased at a time.

The rewrite count area 100B is composed of rewrite count areas 1 - n each corresponding to one of blocks 1 - n of the rewrite area 100C, as shown in FIG. 1 (c). Each of these areas contains the rewrite count data of each block.

Each of rewrite count areas 1 - n forms one block of the rewire count area, e.g., of 13-byte, containing the rewrite count of the corresponding block, as shown in FIG. 1 (d). The rewrite count is represented by the number of a bit (bit position) in the 13 bytes whose initial value of "1" is changed to "0". For example, when data has been rewritten 10 times, the tenth bit (bit 9 with the Least Significant Bit (LSB) being bit 0) is changed from the initial value of "1" to "0".

Each rewrite count area is 13 bytes long. This is because the maximum allowable rewrite count of a flash memory installed on a microcomputer is about 100 (the memory can be rewritten up to 100 times). That is, counting 100 times of rewriting using the number of bits whose values have been changed requires a bit string at least 13 bytes (104 bits) long.

When the CPU executes a self-program etc. stored in the program execution area 100A of the flash memory 100 to rewrite the rewrite area, the program checks a rewrite count area corresponding to a block to be rewritten. If the number of bits whose values have been changed ("1"→"0") is equal to or smaller than 100 (i. e., equal to or smaller than a maximum allowable rewrite count number 100), the program erases the corresponding block in the rewrite area and writes new data there. Then, the program changes the bit, corresponding to the rewrite count of the bit string of the corresponding block, from the initial value of "1" to "0" to increment the rewrite count.

Conversely, if the number of bits whose values have been changed exceeds 100, the program inhibits the rewriting of the block because the maximum allowable rewrite count of the block is exceeded.

The number of rewrites of the flash memory is counted by counting the number of bits that have been changed from the initial value of "1" to "0". This is done, not by erasing, but by simply overwriting, the bit, making the flash memory less likely to be affected by erasing. Therefore, even if the rewrite area has been rewritten almost as many times as the maximum allowable rewrite count, this method minimizes the deterioration of the rewrite count storage area of the flash memory and makes the data reliability of the rewrite count area higher than that of the rewrite area.

The deterioration of flash memory occurs primarily through the erase operation but little or no through the write operation.

Structurally, all the bits of the flash memory are FFH when erased (H represents a hexadecimal number with all "1" bits in one byte). A program is written into the flash memory by changing the required bits to 0s.

Therefore, all the bytes of the rewrite count area initially contain FFH and, each time the area is rewritten, the corresponding 1 bit of the 13-byte bit string is changed from "1" to "0". In this manner, the rewrite count may be changed by the write operation that is done only through overwriting.

Because this operation does not erase the flash memory as described above, the deterioration of the flash memory is minimized.

FIG. 3 shows the configuration of the embodiment of the present invention. Referring to FIG. 3, the flash memory has the configuration shown in FIG. 1 (The flash memory comprises the program execution area 100A, rewrite count area 100B, and rewrite area 100C). This configuration allows the rewrite count to be managed by the rewrite count area within the flash memory 100, thereby eliminating the need for an external non-volatile memory, such as the one shown in FIG. 4, for managing the rewrite count of the flash memory.

Next, a second embodiment of the present invention will be described. In the second embodiment of the present invention, the rewrite count storage area 100B of the flash memory is configured as shown in FIG. 2 (b). That is, the 3-byte area is composed of low-order 16 bits x high-order 8 bits (a total of 24 bits). The rewrite count is hold by the changing number of the bit value ("1"→"0").

In the first embodiment described above, the rewrite count area in the rewrite count storage area 100B corresponding to each block is composed of a bit string long enough to contain a number of bits equal to or more than the maximum allowable rewrite count, as shown in FIG. 2 (a). In the second embodiment of the present invention, the rewrite count area is 24 bits long as shown in FIG. 2 (b) to count a maximum of 128 (16 x 8). Therefore, the rewrite count storage area in this embodiment is smaller than that of the rewrite count storage area in the first embodiment described above.

As for the low-order 16 bits, rewriting is performed by 7 times (100 ÷ 16 bits = 6.25 times) for the 100 times of the maximum allowable rewrite count. Because the number of rewriting 7 times is much smaller than 100 times of the maximum allowable rewrite count, the reliability of rewrite count data is ensured enough.

Thus, the size of the rewrite count area in the second embodiment is much smaller than that of the rewrite count area in the first embodiment described above. Even if the maximum allowable rewrite count increases, the rewrite count may be managed without increasing the rewrite count storage area to a large extent.

For example, the rewrite count of 32 bits x 32 bits are enough to manage 1000 rewrites. This means that 1000 bits of the storage area may be reduced by about 1/15.

The meritorious effects of the present invention are summarized as follows.

According to the present invention, a deterioration in the characteristics of the rewrite count flash memory area that is caused by the erase operation may be prevented and the reliability of the rewrite count data is increased. The reason is that, in the embodiments of the present invention, the rewrite count management counter is incremented only by the overwrite operation.

According to the present invention, the count of flash memory rewriting, which is performed during self-programming and so on, may be managed without recourse to an external non-volatile memory. This configuration therefore reduces the cost.

It should be noted that other objects, features and aspects of the present invention will become apparent in the entire disclosure and that modifications may be done without departing the gist and scope of the present invention as disclosed herein and claimed as appended herewith.

Also it should be noted that any combination of the disclosed and/or claimed elements, matters and/or items may fall under the modifications aforementioned.

## Claims

1. A flash memory rewrite management method, said method comprising the steps of:
providing a rewrite count area that manages rewrite count data of a rewrite area, said rewrite count area being provided in the flash memory in addition to said rewrite area to be rewritten;
providing, in said rewrite count area, a rewrite count management area for each of blocks constituting said rewrite area; and
when a block in said rewrite area is rewritten, changing a value of a bit position corresponding to a rewrite count of said block said bit position being in said rewrite count management area corresponding to said block.

2. The flash memory rewrite management method as defined by claim 1, further comprising the steps of:
searching said rewrite count area for said rewrite count management area corresponding to said block upon rewriting said block included in said rewrite area;
determining the rewrite count based on data of bit or bits, whose value has been changed in said rewrite count management area; and
erasing said block and writing data therein, if said rewrite count is equal to or smaller than a predetermined maximum rewrite count.

3. The flash memory rewrite management method as defined by claim 1,
wherein each of said rewrite count management areas, each corresponding to one of the blocks, in said rewrite count area is composed of a bit string comprising a number of bits equal to or larger than a predetermined maximum rewrite count, said bit string being preset to a predetermined value, and
wherein, when said block is rewritten, the value of the bit position corresponding to the rewrite count is changed, said bit position being within the bit string in said rewrite count management area in said rewrite count area, said rewrite count management area corresponding to said block.

4. The flash memory rewrite management method as defined by claim 1,
wherein each of said rewrite count management areas, each corresponding to one of the blocks, in said rewrite count area is divided into a high-order bit string of a first number of bits and a low-order bit string of a second number of bits, a value of a product of said first number of bits and said second number of bits being equal to or larger than a maximum of the rewrite count of said flash memory, said high-order and said tow-order bit strings each being preset to a predetermined value, and
wherein, when said block is rewritten, the value of said high-order bit string and/or said low-order bit string corresponding to the rewrite count is changed, said high-order bit string and/or said low-order bit string being in said rewrite count management area in said rewrite count area, said rewrite count management area corresponding to said block.

5. A microcomputer with a flash memory, said microcomputer reading a program from a program execution area in said flash memory to cause said program to perform self-programming operation which rewrites a rewrite area in said flash memory,
wherein said flash memory further comprises, in addition to said program execution area and said rewrite area, a rewrite count area that manages rewrite count data on said rewrite area,
wherein said rewrite count area comprises a plurality of rewrite count management areas each corresponding to one of blocks constituting said rewrite area; and
wherein, when one of the blocks in said rewrite area is rewritten, a value of a bit position corresponding to a rewrite count of said block is changed, said bit being in said rewrite count management area corresponding to said block.

6. The microcomputer having the flash memory as defined by claim 5, wherein, when one of the blocks of said rewrite area is rewritten, said microcomputer searches said rewrite count area for said rewrite count management area corresponding to said block; determines the rewrite count from bit data whose value has been changed in said rewrite count management area; and, if said rewrite count is equal to or smaller than a predetermined maximum rewrite count, erases said block and writes data therein.

7. The microcomputer having the flash memory as defined by claim 5,
wherein each of said rewrite count management areas, each corresponding to one of the blocks, in said rewrite count area is composed of a bit string comprising a number of bits equal to or larger than a predetermined maximum rewrite count, said bit string being preset to a predetermined value, and
wherein, when one block of said rewrite area is rewritten, the value of the bit position corresponding to the rewrite count is changed, said bit position being in the bit string of said rewrite count management area in said rewrite count area, said rewrite count management area corresponding to said block.

8. The microcomputer having the flash memory as defined by claim 5,
wherein each of said rewrite count management areas, each corresponding to one of the blocks, in said rewrite count area is divided into a high-order bit string of a first number of bits and a low-order bit string of a second number of bits, a value of a product of said first number of bits and said second number of bits being equal to or larger than a maximum of the rewrite count of said flash memory, said bit strings each being preset to a predetermined value, and
wherein, when the block of said rewrite area is rewritten, the value of said high-order bit string and/or said low-order bit string corresponding to the rewrite count is changed, said high-order bit string and/or said low-order bit string being in said rewrite count management area corresponding to said block.
